# EUROPÄISCHE PATENTSCHRIFT

(11) **EP 1 050 597 B1**
(45) Veröffentlichungstag und Bekanntmachung des Hinweises auf die Patenterteilung: **27.04.2005**
(21) Anmeldenummer: 00107653.8
(22) Anmeldetag: 10.04.2000
(51) Int. Cl.: C23C 14/50

(54) **Vakuum-Beschichtungsanlage**
Vacuum coating apparatus
Appareil de dèpôt sous vide

(30) Priorität: 04.05.1999 CH 82299
(43) Veröffentlichungstag der Anmeldung: 08.11.2000
(73) Patentinhaber: Satis Vacuum Industries Vertriebs - AG, 6341 Baar (CH)
(72) Erfinder: Siegrist, Beat, 8704 Herrliberg (CH)
(74) Vertreter: Petschner, Goetz

(56) Entgegenhaltungen:
- US-A- 3 799 110
- US-A- 4 817 559
- US-A- 5 026 469
- US-A- 5 124 019
- PATENT ABSTRACTS OF JAPAN vol. 010, no. 148 (C-350), 29. Mai 1986 (1986-05-29) & JP 61 006273 A (NIPPON SHINKU GIJUTSU KK), 11. Januar 1986 (1986-01-11)

## Beschreibung

Die vorliegende Erfindung betrifft eine Vakuum-Beschichtungsanlage zum Aufdampfen von Vergütungsschichten auf optische Substrate, wie Kunststoff-Brillengläser, welche auf domförmige Trägermittel aufspannbar sind, die in einem evakuierbaren Rezipienten oberhalb von Verdampfungsquellen mit einer Drehachse drehfest umlaufen.

Problematisch bei solchen Anlagen ist die Einbringung und Befestigung der ausserhalb der Beschichtungsanlage mit einer grossen Anzahl Substrate bestückten Trägermittel, die zusammen mit den Substraten ein erhebliches Gewicht aufweisen und nur mühsam in Montageposition bringbar sind, um über Flanschmittel o. dgl. mit der Drehachse der Anlage durch Verschraubung oder mittels Bayonettverschluss drehfest verbunden zu werden und vice versa.

Es ist deshalb Aufgabe der vorliegenden Erfindung, eine Vakuum-Beschichtungsanlage der vorgenannten Art zu schaffen, bei welcher die Einbringung und Befestigung der ausserhalb der Beschichtungsanlage mit Substrate bestückten Trägermittel leicht und sicher vorgenommen werden kann und vice versa.

Dies wird erfindungsgemäss dadurch erreicht, dass innenseitig des Rezipienten mit der Drehachse drehfest ein der einschiebbaren und verriegelbaren Aufnahme des Substrat-Trägers dienender Rahmen verbunden ist.

Durch diese Massnahme ist es nunmehr möglich, einen bestückten Substrat-Träger, beispielsweise mittels Heber, wie Gabelstabler o.dgl., auf die Einschubhöhe zu bringen, um dann den Substrat-Träger horizontal in den Rahmen einzuschieben und zu verriegeln, beispielsweise mittels Klinkenmittel, und vice versa.

In der Regel sind solche Substrat-Träger dom- oder kuppelförmig ausgestaltet. Um dieser Wölbung der Substrat-Träger zu genügen, ist der Rahmen über geneigte Speichen an der Drehachse abgestützt. Um dann den Substrat-Träger auf den Rahmen schieben zu können, sind mit dem Rahmen drei Speichen verbunden, von denen zwei Speichen in Umfangsrichtung um 180° versetzt angeordnet sind und sich die dritte Speiche symmetrisch dazwischen befindet.

Eine beispielsweise Ausführungsform der erfindungsgemässen Vakuum-Beschichtungsanlage ist nachfolgend anhand der Zeichnung näher erläutert. Es zeigen:

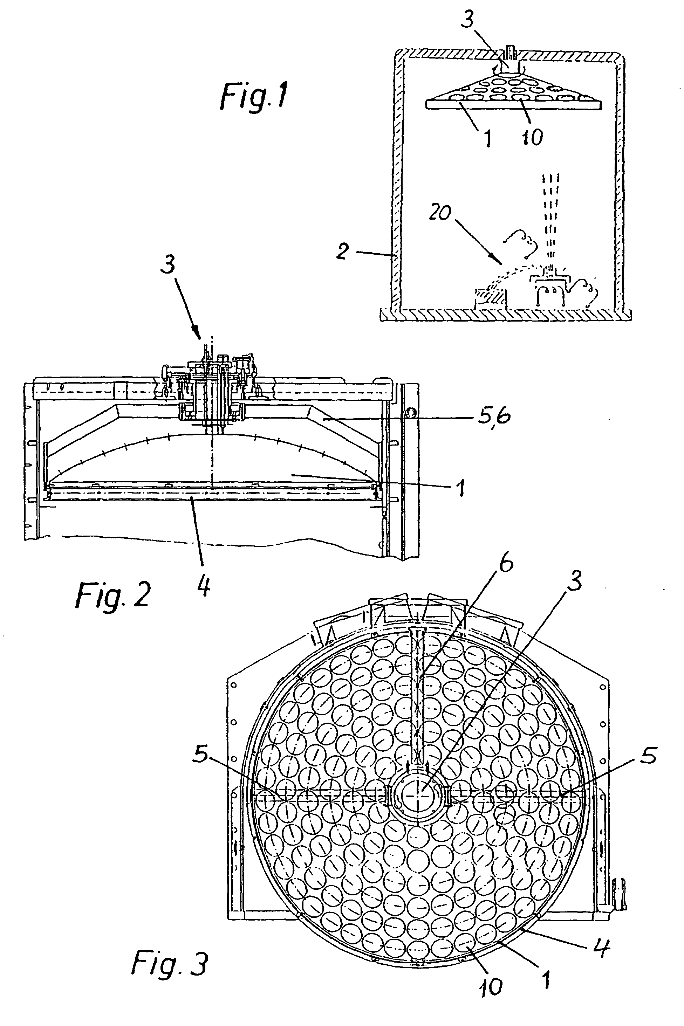

- Fig.1: eine Vakuum-Beschichtungsanlage, im Schnitt; und
- Fig. 2 u.3: in Seitenansicht und Draufsicht in grösserem Masstab einen Aufnahme-Rahmen für die Anlage gemäss Fig. 1.

Die gezeigte Vakuum-Beschichtungsanlage dient zum Aufdampfen von Vergütungsschichten auf optische Substrate 10, wie Kunststoff-Brillengläser, welche auf domförmige Trägermittel 1 aufspannbar sind, die in einem evakuierbaren Rezipienten 2 oberhalb von Verdampfungsquellen 20 mit einer Drehachse 3 drehfest umlaufen.

Der Aufbau solcher Vakuum-Aufdampfanlagen ist soweit bekannt, dass sich eine nähere Konstruktionsbeschreibung erübrigt.

Erfindungswesentlich ist hier, dass innenseitig des Rezipienten 2 mit der Drehachse 3 drehfest ein der einschiebbaren und verriegelbaren Aufnahme des Substrat-Trägers 1 dienender Rahmen 4 verbunden ist.

Ein bestückter Substrat-Träger 1 kann nun, beispielsweise mittels Heber, wie Gabelstabler o.dgl. (nicht gezeigt) oder von Hand, auf die Einschubhöhe gebracht werden, um dann den Substrat-Träger 1 horizontal in den Rahmen 4 einzuschieben und zu verriegeln, beispielsweise mittels Klinkenmittel (nicht gezeigt), und vice versa.

Wie bereits erwähnt, sind solche Substrat-Träger 1 in der Regel dom- oder kuppelförmig ausgestaltet. Entsprechend der Wölbung der Substrat-Träger 1 ist der Rahmen 4 über geneigte Speichen 5,6 an der Drehachse abgestützt. Um dann den Substrat-Träger 1 auf den Rahmen 4 schieben zu können, sind mit dem Rahmen 4 drei Speichen 5,6 verbunden, von denen zwei Speichen 5 in Umfangsrichtung um 180° versetzt angeordnet sind und sich die dritte Speiche 6 symmetrisch dazwischen befindet.

Durch diese Massnahme ist es nunmehr möglich, einen bestückten Substrat-Träger horizontal in den Rahmen einzuschieben und zu verriegeln und vice versa.

## Patentansprüche

1. Vakuum-Beschichtungsanlage zum Aufdampfen von Vergütungsschichten auf optische Substrate, wie Kunststoff-Brillengläser, welche auf domförmige Trägermittel (1) aufspannbar sind, die in einem evakuierbaren Rezipienten (2) oberhalb von Verdampfungsquellen (20) mit einer Drehachse (3) drehfest umlaufen, **dadurch gekennzeichnet,**
**dass** innenseitig des Rezipienten (2) mit der Drehachse (3) drehfest ein der einschiebbaren und verriegelbaren Aufnahme des Substrat-Trägers (1) dienender Rahmen (4) verbunden ist.

2. Vakuum-Beschichtungsanlage nach Anspruch 1, **dadurch gekennzeichnet, dass** der Rahmen (4) über geneigte Speichen (5,6) an der Drehachse (3) abgestützt ist.

3. Vakuum-Beschichtungsanlage nach Anspruch 2, **dadurch gekennzeichnet, dass** mit dem Rahmen drei Speichen (5,6) verbunden sind, von denen zwei Speichen (5) in Umfangsrichtung um 180° versetzt angeordnet sind und sich die dritte Speiche (6) symmetrisch dazwischen befindet.

## Claims

1. A vacuum deposition system to deposit blooming coats on optical substrates such as plastic glasses that can be clamped onto dome-shaped supports (1) which rotate in evacuable recipients (2) above vaporization sources (20) with a rotary axis (3) fixed against rotation, **characterized in that** a frame (4) to receive the insertable and lockable substrate carrier (1) is fixed against rotation to the rotary axis (3) inside the recipient (2).

2. A vacuum deposition system according to claim 1, **characterized in that** the frame (4) is supported by angled spokes (5, 6) on the rotary axis (3).

3. A vacuum deposition system according to claim 2, **characterized in that** there are three spokes (5, 6) connected to the frame of which two spokes (5) are offset 180° in a peripheral direction, and the third spoke (6) lies symmetrically between.

## Revendications

1. Installation de dépôt sous vide pour la métallisation sous vide de couches de traitement sur des substrats optiques, comme des verres de lunettes en matériau synthétique, qui peuvent être serrées sur des moyens de support (1) en forme de dôme qui tournent dans un récipient pouvant être évacué (2) au-dessus de sources d'évaporation (20) d'une manière non tournante avec un axe de rotation (3), **caractérisée en ce qu'**au côté intérieur du récipient (2) est relié à l'axe de rotation (3) d'une manière non tournante un cadre (4) servant à la réception insérable et verrouillable du porte-substrats (1).

2. Installation de dépôt sous vide selon la revendication 1, **caractérisée en ce que** le cadre (4) s'appuie par des rayons inclinés (5,6) à l'axe de rotation (3).

3. Installation de dépôt sous vide selon la revendication 2, **caractérisée en ce que** trois rayons (5,6) sont reliés au cadre dont deux rayons (5) sont disposés d'une manière décalée dans la direction périphérique de 180° et que le troisième rayon (6) se trouve symétriquement entre ceux-ci.
